# EUROPEAN PATENT APPLICATION

(11) **EP 2 677 541 A1**
(43) Date of publication of application: **25.12.2013**
(21) Application number: 12172513.9
(22) Date of filing: 19.06.2012
(51) Int. Cl.: H01L 23/49, H01L 21/60, H01L 25/07

(54) **Method for wire bonding a power semiconductor chip and the corresponding device**

(71) Applicant: ABB Technology AG, 8050 Zürich (CH)
(72) Inventor: Geissmann, Silvan, 5605 Dottikon (CH); Özkol, Emre, 8048 Zürich (CH)
(74) Representative: ABB Patent Attorneys

(57) **Abstract**

The present invention provides a method for bonding a contact pad (9) of a power semiconductor (3), which is arranged on a substrate (1), to a metallization (7) of the substrate (1), comprising the steps of bonding at least one bonding means (11) of soft metal between the metallization (7) and the contact pad (9), and positioning the substrate (1) with the power semiconductor (3) and the at least one bonding means (11) of soft metal in a depositing bath for depositing a layer (13) of hard metal on the contact pad (9) and the at least one bonding means (11) of soft metal. The present invention also provides a substrate (1) with a power semiconductor mounted thereon, whereby the substrate (1) comprises metallization (7), the power semiconductor (3) has a contact pad (9), and at least one bonding means (11) of soft metal is bonded between the contact pad (9) and the metallization (7), whereby the at least one bonding means (11) of soft metal and the contact pad (9) have a layer (13) of hard metal deposited thereon.

## Description

### Technical Field

The present invention relates to a method for bonding a contact pad of a power semiconductor, which is arranged on a substrate, to a metallization of the substrate. The present invention also relates to a substrate with a power semiconductor mounted thereon, whereby the substrate comprises a metallization, the power semiconductor has a contact pad, and at least one bonding means of soft metal is bonded between the contact pad and the metallization.

### Background Art

The electrical connection of power semiconductors on substrates is an important issue, especially in the area of power transmission and power switching. Accordingly, high voltages and currents can be applied to the power semiconductors, so that an insufficient electrical connection between the contact pad of the power semiconductor to the metallization on the substrate can cause problems which can lead to failure of the power semiconductor. The failure can turn functional units comprising such power semiconductors and substrates, e.g. power semiconductor modules comprising multiple substrates with multiple power semiconductors mounted on each substrate, unusable or even lead to destruction of these functional units.

In common power semiconductor modules, two to six substrates of the above-mentioned kind are combined, whereby each substrate is provided with five to six power semiconductors. The power semiconductors are typically chosen from power transistors like insulated gate bipolar transistors (IGBT) or reverse conducting insulated gate bipolar transistors (RC-IGBT), power diodes, or others.

In this technical area, the power semiconductor is arranged on and electrically connected to a metalized contact area of the substrate with one of its electric contacts by means of soldering or sintering. In case of an IGBT or RC-IGBT, the semiconductor is typically mounted with its collector. The contact pad is provided on the upper surface of the power semiconductor, i.e. the surface opposite to the substrate, and bonded with at least one bonding means to the metallization. The bonding means are typically provided as bonding wires or bonding ribbons. In case of power transistors, typically two contact pads are provided on its upper surface, whereby one contact pad belongs to the emitter and the other one to the gate. In that case, a further metallization is provided on the substrate for connecting the second contact pad.

The contact pads of the power semiconductors as well as the bonding means are usually made of aluminum. The bonding means are connected to the contact pads and the metallization on the substrate by processes using soldering or welding techniques, as known in the art. In particular, in case of power semiconductors, multiple bonding means can be required for connecting a single contact pad, for example for connecting the emitter of an IGBT to the respective metallization, in order to operate the IGBT with specified currents and voltages. In particular, when bonding wires are used, multiple bonding wires can be required.

Aluminum is a relatively soft metal. Accordingly, cyclic thermo-mechanical stress causes fatigue and crack-propagation of the bonding means and their connection to the contact pad. E.g. bonding wire lift-off defects can occur, so that the current is carried by the remaining bonding wires, which are still in contact with the contact pad. Hence, the current through single bonding wires can reach critical limits resulting in a current overload. Also other bonding means like bonding ribbons can suffer from lift-off defects. The metallization is frequently made of hard metal, so that the connection of the at least one bonding means to the metallization is not critical.

To improve the thermo-mechanical stress resistance of the bonding means and their connection to the contact pad of the power semiconductor, one approach is to use bonding means, e.g. bonding wires, made of harder materials than aluminum, for example copper or nickel. Accordingly, the bonding wires are harder than the contact pads, so that the contact pads can be mechanically damaged during bonding. Also bonding means combining different materials are known in the art, e.g. a bonding wire with a core of hard metal and an aluminum skin, or a bi-metal ribbon with an aluminum layer on its bottom side and a hard metal layer on its top side. This bi-metal ribbon is bonded with its bottom side to the contact pad. These bonding means have the same disadvantages in respect to fatigue and crack propagation as discussed before, since the connection between the bonding means and the contact pad is based on a connection between aluminum and aluminum. Accordingly, thermo-mechanical stress resistance is still not sufficient.

### Disclosure of Invention

It is an object of the present invention to provide a method for bonding a contact pad of a power semiconductor, which is arranged on a substrate, to a metallization of the substrate, which increases resistance to thermo-mechanical stress and which can easily be applied to common processes for mounting and connecting a power semiconductor on and to a substrate. It is further object of the present invention to provide a substrate with a power semiconductor mounted thereon of the above mentioned kind, which has improved bonding connections with increased thermo-mechanical stress resistance and which is easy to manufacture based on common manufacturing processes.

These objects are achieved by the independent claims. Advantageous embodiments are given in the dependent claims.

In particular, the present invention provides a method for bonding a contact pad of a power semiconductor, which is arranged on a substrate, to a metallization of the substrate, comprising the steps of bonding at least one bonding wire of soft metal between the metallization and the contact pad, and positioning the substrate with the power semiconductor and the at least one bonding means of soft metal in a depositing bath for depositing a layer of hard metal on the contact pad and the at least one bonding means of soft metal.

The present invention also provides a substrate with a power semiconductor mounted thereon, whereby the substrate comprises a metallization, the power semiconductor has a contact pad, and at least one bonding means of soft metal is bonded between the contact pad and the metallization, whereby the at least one bonding means of soft metal and the contact pad have a layer of hard metal deposited thereon.

The basic idea of the invention is to add a plating step in a manufacturing process of a substrate with a power semiconductor mounted thereon, so that the bonding of the at least one bonding means to the contact pad is reinforced. This refers to the bonding means itself as well as to the connection between the bonding means and the contact pad. Accordingly, a common power semiconductor having a common contact pad made of soft metal, in particular made of aluminum, can be commonly connected to bonding means of soft metal, in particular made of aluminum, which is a typical bonding process known in the art. The improvement in thermo-mechanical stress resistance is achieved by the layer of hard metal covering the soft metal, which results in increased power cycling capabilities. The layer of hard metal extends at least over the contact pad and the at least one bonding means, forming a continuous layer. The power semiconductor is a power transistor, e.g. an insulated gate bipolar transistor (IGBT) or a reverse conducing insulated gate bipolar transistor (RC-IGBT), or a power diode. The power semiconductor is preferably sintered or soldered with one of its electric contacts to a metalized contact area, which is formed on the substrate. A power transistor is typically mounted with its collector on the metalized contact area, whereas emitter and gate are provided with contact pads on the opposite side of the power semiconductor. These contact pads are individually bonded to respective metallizations on the substrate. Furthermore, a chip contact can comprise multiple contact pads, e.g. multiple contact pads for the emitter. Nevertheless, the inventive method can be equally applied. The inventive method can also be applied without modifications for simultaneously bonding contact pads of multiple power semiconductors, which are arranged on the same substrate. Preferably, the depositing bath is a chemical depositing bath. Further preferred, the hard metal layer comprises at least two individual sublayers of hard metal. The bonding means are preferably provided as bonding wires or bonding ribbons.

According to a modified embodiment of the invention the step of positioning the substrate with the power semiconductor and the at least one bonding means of soft metal in a depositing bath comprises electrically connecting the metallization to an electric potential and electrically depositing the layer of hard metal on the contact pad and the at least one bonding means of soft metal. Accordingly, the method is realized comprising electroplating. The electric potential is provided from the metallization via the bonding means to the contact pad. The substrate with the power semiconductor and the at least one bonding means are emerged in the depositing bath and ions of hard metal from the depositing bath are attracted by the potential of the contact pad and the at least one bonding means, so that the ions are deposited thereon forming the layer of hard metal. When using electroplating, the process of depositing the hard metal layer on the contact pad and the at least one bonding means can be easily controlled to achieve a hard metal layer having a desired thickness. With electroplating, in general a high thickness of the hard metal layer can be achieved. Preferably, the applied electric potential and the duration of the electroplating step are controlled to obtain a desired thickness of the layer of hard metal. The hard metal layer is only deposited on surfaces connected to the electric potential. Therefore, the electric connection between the metallization and the contact pad prior to the depositing step is required, so that the electric potential is applied also to the contact pad. Furthermore, in case the power semiconductor is a power transistor the contact pads of gate and emitter are bonded to different metallizations. Accordingly, the electric potential has to be applied to both metallizations. Otherwise, the layer of hard metal will only be formed on the bonding means and the contact pad where the potential is applied. As a secondary effect, also the metallizations connected to the potential will be plated.

According to a modified embodiment of the invention the step of depositing the layer of hard metal on the contact pad and the at least one bonding means of soft metal comprises the step of depositing at least a first sublayer of hard metal using a chemical depositing bath and at least a second sublayer of hard metal using electroplating, whereby the sublayers form the hard metal layer. The at least one first and second sublayer can be formed in any particular order on the contact pad and the at least one bonding means. The first and second sublayers can comprise any suitable hard metal.

According to a modified embodiment of the invention the step of electrically connecting the metallization to an electric potential comprises providing an auxiliary pin on the substrate, which is connected to the metallization, and connecting the auxiliary pin to the electric potential. The auxiliary pin facilitates the connection of the metallization to the electric potential. In case of the use of power transistors as power semiconductors, all metallizations are connected to an auxiliary pin, either a common auxiliary pin or individual auxiliary pins, to apply the electric potential to both metallizations.

According to a modified embodiment of the invention the method comprises the subsequent step of bonding at least one bonding means of hard metal between the metallization and the layer of hard metal deposited on the contact pad. Accordingly, at least one bonding means of hard metal is bonded between the hard metal layer of the contact pad and the metallization. Once the contact pad is covered with the layer of hard metal, bonding means of hard metal can be directly connected to the contact pad without the risk of damaging the power semiconductor during bonding. In particular, when electroplating is used for depositing the hard metal layer on the contact pad and the at least one bonding means, an electrically conducting connection between the metallization and the respective contact pad is required for depositing the layer of hard metal. Preferably, only one bonding means of soft metal is bonded between the metallization and the contact pad. Also the bonding means of hard metal are preferably provided as bonding wires or bonding ribbons.

According to a modified embodiment of the invention the step of depositing a layer of hard metal on the contact pad and the at least one bonding means of soft metal comprises depositing a layer of copper or nickel on the contact pad and the at least one bonding means of soft metal. Copper and nickel both are sufficiently hard for increasing thermo-mechanical stress resistance and can be applied by the inventive method to form a depositing layer on the contact pad and the at least one bonding means. Also electrical characteristics of copper and nickel are suitable for the use in the area of power semiconductors.

According to a preferred embodiment of the invention the step of depositing a layer of hard metal on the contact pad and the at least one bonding means of soft metal comprises depositing a layer of hard metal with a thickness of 5-200 µm on the contact pad and the at least one bonding means of soft metal. The thickness of the hard metal layer is important for an improved current distribution, e.g. on the contact pad. Furthermore, also the mechanical strength of the at least one bonding means and the contact pad as well as the mechanical strength of their connections are improved with an increased thickness of the layer of hard metal. Preferably, the layer of hard metal has a thickness of 50-200 µm.

According to a preferred embodiment of the invention the step of bonding at least one bonding means of soft metal comprises bonding a bonding wire of soft metal with a diameter of not more than 375 µm. Accordingly, the bonding wire made of soft metal has a reduced diameter compared to a typical bonding wire in the area of power semiconductors, where bonding wires of up to 500 µm are used as bonding means due to the applied high currents. With the layer of hard metal deposited thereon, a typical thickness of the at least one bonding wire can be achieved, so that the electric performance of a conventionally bonded power semiconductor can be achieved with the same number of bonding wires. With the at least one bonding wire of soft metal having a reduced diameter, layout and placement of the bonding wires are facilitated. Also the number of bonding wires connected to the contact pad can be increased to allow increased currents.

According to a preferred embodiment of the invention the step of bonding at least one bonding means of soft metal comprises bonding a bonding wire of soft metal with a diameter of at least 500 µm. In the area of power semiconductors, typically bonding wires of up to 500 µm are used due to the applied high currents. With the layer of hard metal deposited thereon, bonding wires can be easily formed with an increased diameter, so that higher currents can be applied. Nevertheless, the basic process for bonding the bonding wires of soft metal to the contact pad of soft metal can be any process known in the art without modifications.

### Brief Description of Drawings

These and other aspects of the invention will be apparent from and elucidated with reference to the embodiments described hereinafter.

In the drawings:

Fig. 1 shows a side view of a substrate with a chip bonded by a bonding wire before plating according to a first embodiment of the invention,

Fig. 2 shows the arrangement of Fig. 1 after an additional step of depositing a layer of hard metal according to the first embodiment,

Fig. 3 shows a schematical view of an entire substrate with multiple semiconductors bonded thereto according to a second embodiment of the invention,

Fig. 4 shows a partial view of the substrate and one power semiconductor as shown in Fig. 3, and

Fig. 5 shows a partial view of the substrate and the power semiconductor bonded thereon according to a third embodiment of the invention.

### Detailed Description of the Invention

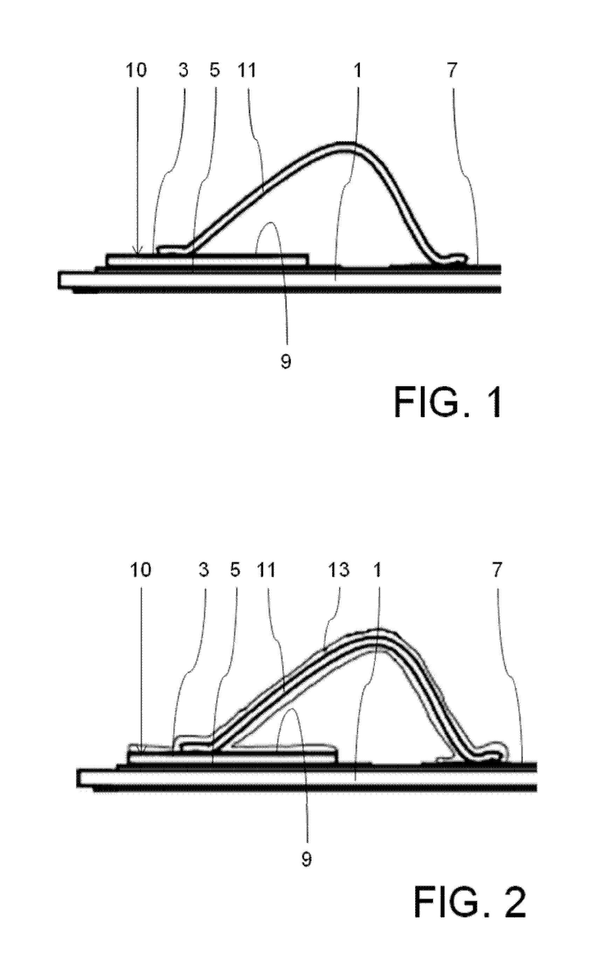

Figs. 1 and 2 illustrate schematically the inventive process for providing a substrate 1 with a power semiconductor 3 mounted thereon, according to a first embodiment. The substrate 1 comprises a metalized contact area 5 and a metallization 7, which are both made of a hard metal, which is copper in this embodiment. The power semiconductor 3 is soldered to the metalized contact area 5 with one of its surfaces, thereby providing a mechanical and electrical connection to the metalized contact area 5. The power semiconductor 3 has a contact pad 9 of aluminum on its top surface 10 opposite to the substrate 1, which is connected by a soft metal bonding means 11 to the metallization 7. The soft metal bonding means 11 in this embodiment is a bonding wire 11 made of aluminum and has a diameter of 500 µm. Accordingly, the substrate 1 with the power semiconductor 3 and aluminum bonding wire 11, as shown in Fig. 1, can be the result of a conventional bonding method.

The substrate 1 with the power semiconductor 3 and the bonding wire 11 is then electroplated. Accordingly, the metallization 7 is connected to an electric potential via an auxiliary pin of the substrate 1, which is not shown in the figures. In a depositing bath, ions of hard metal are electrically deposited on the contact pad 9 and the aluminum bonding wire 11, thereby forming a depositing layer 13 thereon, as shown in Fig. 2.

In this embodiment, the depositing layer 13 is formed of copper with a thickness of 5-200 µm. Accordingly, the aluminum bonding wire 11 with depositing layer 13 deposited thereon has a diameter of more than 500 µm, preferably 510-900 µm. In an alternative embodiment, the depositing layer 13 is formed of nickel.

When the desired thickness of the depositing layer 13 is achieved, the substrate 1 is removed from the depositing bath and the electric potential is disconnected. As a secondary effect, the depositing layer 13 of hard metal is also formed on the metallization 7, since the electric potential is also applied thereto.

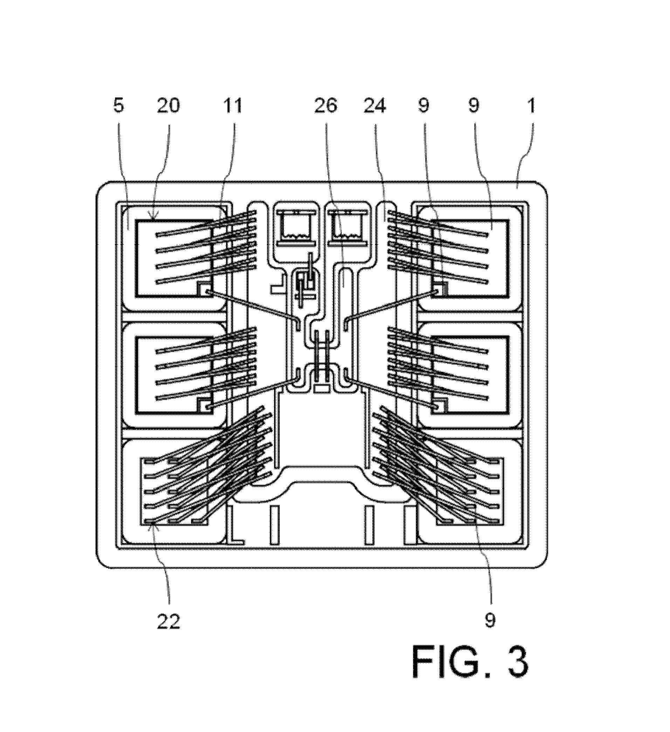

Fig. 3 shows a substrate 1 with multiple power semiconductors 20, 22 mounted thereon, according to a second embodiment of the invention. Since the second embodiment is similar to the first embodiment, same reference numerals are used for like components.

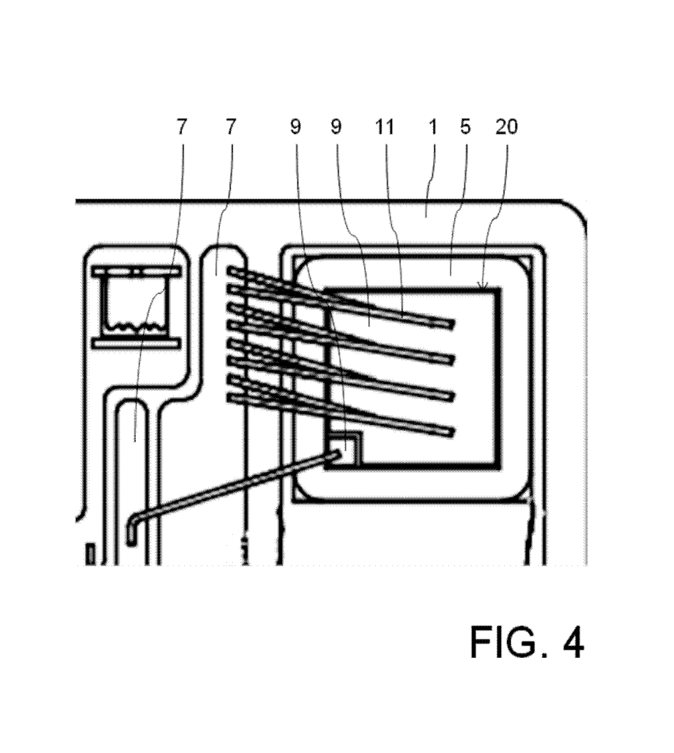

The power semiconductors 20, 22 in the second embodiment are power transistors 20, e.g. insulated gate bipolar transistors (IGBT), and power diodes 22. Four IGBTs 20 and two power diodes 22 are mounted directly with one of their surfaces to a metalized contact area 5 on the substrate 1 by means of sintering or soldering. Two individual metallizations 7 are provided on the substrate 1 and connected by means of aluminum bonding wires 11 as bonding means to the IGBTs 20 and the power diodes 22. The aluminum bonding wires 11 in this embodiment have a diameter of 375 µm. The power diodes 22 have one contact pad 9 on their top side 10, which is connected to one of the metallizations 7, whereas the IGBTs 20 have two contact pads 9 corresponding to emitter and gate of the IGBT 20. The two contact pads 9 of the IGBT 20 are individually bonded each to one metallization 7. As shown in detail in Fig. 4, the aluminum bonding wires 11 and the contact pad 9 have a depositing layer 13 of hard metal deposited thereon after applying the process described before in respect to the first embodiment. The depositing layer 13 in this embodiment is made of copper as described before in respect to the first embodiment and has a thickness of 50-200 µm.

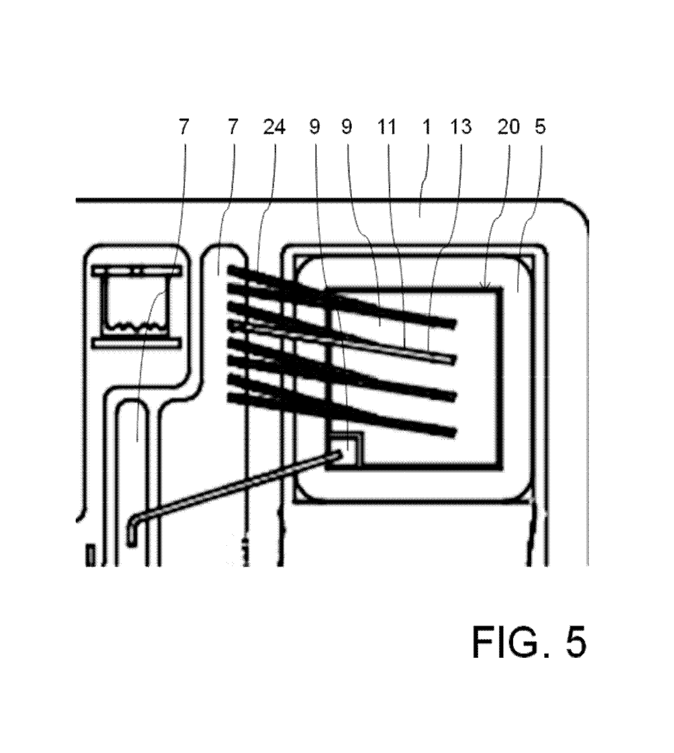

Fig. 5 shows a substrate 1 with a power semiconductor 20 mounted thereon according to a third embodiment of the invention. Since the third embodiment is similar to the second embodiment, same reference numerals are used for similar components.

According to the third embodiment, also a substrate 1 is provided with a power transistor 20, in this case an insulated gate bipolar transistor (IGBT), mounted thereon as described before. Initially, each contact pad 9 of the IGBT 20 is connected to one metallization 7 on the substrate 1 with one aluminum bonding wire 11 as bonding means. Subsequently, the depositing step as described above is applied, thereby forming a depositing layer 13 of hard metal on the two aluminum bonding wires 11 and the contact pads 9.

After depositing the depositing layer 13 of hard metal on the aluminum bonding wires 11 and the contact pads 9 of the IGBT 20, hard metal bonding means 24 are bonded between the metallization 7 and one contact pad 9 onto the depositing layer 13 of hard metal. The hard metal bonding means 24 in this embodiment are bonding wires made of copper.

While the invention has been illustrated and described in detail in the drawings and foregoing description, such illustration and description are to be considered illustrative or exemplary and not restrictive; the invention is not limited to the disclosed embodiments. Other variations to be disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting scope.

### Reference signs list

1 substrate
3 power semiconductor
5 contact area
7 metallization
9 contact pad
10 top surface
11 soft metal bonding means, aluminum bonding wire
13 depositing layer of hard metal
20 power semiconductor, IGBT
22 power semiconductor, power diode
24 hard metal bonding means, hard metal bonding wire

## Claims

1. Method for bonding a contact pad (9) of a power semiconductor (3, 20, 22), which is arranged on a substrate (1), to a metallization (7) of the substrate (1), comprising the steps of
bonding at least one bonding means (11) of soft metal between the metallization (7) and the contact pad (9), and
positioning the substrate (1) with the power semiconductor (3, 20, 22) and the at least one bonding means (11) of soft metal in a depositing bath for depositing a layer (13) of hard metal on the contact pad (9) and the at least one bonding means (11) of soft metal.

2. Method according to preceding claim 1,
**characterized in that**
the step of positioning the substrate (1) with the power semiconductor (3, 20, 22) and the at least one bonding means (11) of soft metal in a depositing bath comprises electrically connecting the metallization (7) to an electric potential and electrically depositing the layer (13) of hard metal on the contact pad (9) and the at least one bonding means (11) of soft metal.

3. Method according to preceding claim 2,
**characterized in that**
the step of electrically connecting the metallization (7) to an electric potential comprises providing an auxiliary pin on the substrate (1), which is connected to the metallization (7), and connecting the auxiliary pin to the electric potential.

4. Method according to any of any preceding claim,
**characterized in that**
the method comprises the subsequent step of bonding at least one bonding means (24) of hard metal between the metallization (7) and the layer (13) of hard metal deposited on the contact pad (9).

5. Method according to any preceding claim,
**characterized in that**
the step of depositing a layer (13) of hard metal on the contact pad (9) and the at least one bonding means (11) of soft metal comprises depositing a layer (13) of copper or nickel on the contact pad (9) and the at least one bonding means (11) of soft metal.

6. Method according to any preceding claim,
**characterized in that**
the step of depositing a layer (13) of hard metal on the contact pad (9) and the at least one bonding means (11) of soft metal comprises depositing a layer (13) of hard metal with a thickness of 5-200 µm on the contact pad (9) and the at least one bonding means (11) of soft metal.

7. Method according to any preceding claim,
**characterized in that**
the step of bonding at least one bonding means (11) of soft metal comprises bonding a bonding wire (11) of soft metal with a diameter of not more than 375 µm.

8. Method according to any of preceding claims 1 to 6,
**characterized in that**
the step of bonding at least one bonding means (11) of soft metal comprises bonding a bonding wire (11) of soft metal with a diameter of at least 500 µm.

9. Substrate (1) with a power semiconductor mounted thereon, whereby the substrate (1) comprises a metallization (7),
the power semiconductor (3, 20, 22) has a contact pad (9), and
at least one bonding means (11) of soft metal is bonded between the contact pad (9) and the metallization (7),
**characterized in that**
the at least one bonding means (11) of soft metal and the contact pad (9) have a layer (13) of hard metal deposited thereon.

10. Substrate (1) according to any preceding claim,
**characterized in that**
at least one bonding means (24) of hard metal is bonded between the hard metal layer (13) of the contact pad (9) and the metallization (7).
